# EUROPÄISCHE PATENTSCHRIFT

(11) **EP 2 002 519 B1**
(45) Veröffentlichungstag und Bekanntmachung des Hinweises auf die Patenterteilung: **29.10.2014**
(21) Anmeldenummer: 07723167.8
(22) Anmeldetag: 10.03.2007
(51) Int. Cl.: H01S 5/042, H01S 5/022

(54) **SCHALTUNGSANORDNUNG ZUM ERZEUGEN SCHNELLER LASERIMPULSE**
CIRCUIT ARRANGEMENT FOR PRODUCING FAST LASER PULSES
CIRCUIT DE CREATION D'IMPULSIONS LASER RAPIDES

(30) Priorität: 29.03.2006 DE 202006005148 U
(43) Veröffentlichungstag der Anmeldung: 17.12.2008
(73) Patentinhaber: iC-Haus GmbH, D-55294 Bodenheim (DE)
(72) Erfinder: HERZ, Manfred, 55130 Mainz (DE)
(74) Vertreter: Kampfenkel, Klaus
(86) Internationale Anmeldenummer: PCT/EP2007/002115
(87) Internationale Veröffentlichungsnummer: WO 2007/112823

(56) Entgegenhaltungen:
- EP-A- 0 886 350
- EP-A- 1 263 140
- WO-A-02/17451
- DE-C1- 4 036 896
- US-A- 6 005 262
- US-A1- 2005 129 074
- KOHSUKE KATSURA ET AL: "A NOVEL FLIP-CHIP INTERCONNECTION TECHNIQUE USING SOLDER BUMPS FOR HIGH-SPEED PHOTORECEIVERS" JOURNAL OF LIGHTWAVE TECHNOLOGY, IEEE SERVICE CENTER, NEW YORK, NY, US, Bd. 8, Nr. 9, 1. September 1990 (1990-09-01), Seiten 1323-1327, XP000174419 ISSN: 0733-8724

## Beschreibung

Die Erfindung betrifft eine Schaltungsanordnung zum Erzeugen schneller Laserimpulse.

Lasertreiber für Laserdioden, die auch in Verbindung mit Monitordioden und Regeleinrichtungen zum Steuern der Lichtleistung von Laserdioden verwendet werden, sind hinlänglich bekannt. Eine derartige Schaltungsanordnung ist beispielsweise aus der DE 103 44 486 A1 bekannt.

Aus der WO 02/17451 A ist ein Lasermodul mit einer Ansteuerschaltung zum Schalten einer Laserdiode bekannt. Als Energieversorgungsquelle werden vorzugsweise Kondensatoren verwendet. Die Laserdiode, die Kondensatoren und die Ansteuerschaltung sind räumlich von einander getrennt auf derselben Seite einer Leiterplatte angeordnet.

Aus der DE 40 36 896 C1 ist ein Hochstrompulser für die Ansteuerung von Laserdioden bekannt. Auf einer Seitenfläche eines ferromagnetischen Trägerguaders ist die Laserdiode angeordnet, wobei auf einer anderen Seitenfläche des Trägerguaders eine RC- Kombination angeordnet ist.

Aus der US 6,005,262 A ist eine Schaltungsanordnung bekannt, bei der eine vertikal abstrahlende Laserdiode, auch VCSEL genannt, mittels einer Flip-Chip-Bonding-Technik mit einem CMOS-Schaltkreis verbunden ist.

Der Erfindung liegt die Aufgabe zugrunde, eine kompakte Schaltungsanordnung zu schaffen, die schnelle Laserimpulse mit steilen Flanken erzeugen kann.

Das oben genannte technische Problem löst die Erfindung mit den Merkmalen des Anspruchs 1.

Ein Kerngedanke der Erfindung ist darin zu sehen, schnelle Laserimpulse mit einer Schaltungsanordnung zu erzeugen, bei der die elektrischen Verbindungen zwischen einem Lasertreiber, einer Laserdiode und wenigstens einem Kondensator möglichst kleine Induktivitäten aufweisen. Der Kondensator dient dazu, beim Einschalten der Laserdiode zusätzliche Energie an den Lasertreiber abzugeben, damit die Laserdiode Laserimpulse mit sehr steilen Anstiegsflanken erzeugen kann.

Hierzu ist eine Schaltungsanordnung zum Erzeugen schneller Laserimpulse vorgesehen. Das Merkmal "schnelle

Laserimpulse" bedeutet, dass die Impulslänge sehr kurz und die steigenden und fallenden Impulsflanken sehr steil sind. Vorzugsweise liegen die Impulslängen der Laserimpulse im Nanosekundenbereich und die Anstiegs- und Abfallzeiten der Impulsflanken im Picosekundenbereich. Um dies zu erreichen, weist die Schaltungsanordnung eine Leiterplatte auf, auf der ein Halbleiterchip angeordnet ist. Der Halbleiterchip weist einen als Lasertreiber fungierenden integrierten Schaltkreis auf, der zum Schalten einer Laserdiode ausgebildet ist. Die Laserdiode ist wiederum auf dem Halbleiterchip angeordnet und mit diesem elektrisch verbunden. An der Leiterplatte ist weiterhin wenigstens ein Kondensator montiert, der elektrisch mit dem Halbleiterchip verbunden ist. Der Kondensator sorgt dafür, dass beim Schalten der Laserdiode eine zusätzliche Energie an den Halbleiterchip und somit an den Lasertreiber abgegeben wird. Dank dieser besonderen Schaltungsanordnung können die Induktivitäten der elektrischen Verbindungen zwischen den Bauteilen möglichst klein gehalten und Laserimpulse mit sehr steilen Ansteiegsflanken erzeugt werden. Die Induktivitäten der elektrischen Verbindungen können weiter reduziert werden, wenn elektrisch leitfähige, vorzugsweise kugelförmige Elemente oder auch Lötkugeln, die als Bumps oder Solder Balls bekannt sind, zum Einsatz kommen, Hierbei wird der wenigstens eine Kondensator an einer Seite der Leiterplatte angeordnet, wohingegen der Halbleiterchip und die Laserdiode an einer anderen Seite, vorzugsweise an der gegenüberliegenden Seite der Leiterplatte angeordnet sind. Die Leiterplatte weist Leiterbahnen auf, die an der einen Seite der Leiterplatte mit dem wenigstens einen Kondensator und an der anderen Seite der Leiterplatte beispielsweise über Lötkugeln mit dem Halbleiterchip und der Laserdiode verbunden sind. Anstelle von Lötkugeln können geeignete elektrisch leitfähige, vorzugsweise kugelförmige Elemente verwendet werden.

Eine vorteilhafte Weiterbildung sieht vor, dass im Halbleiterchip wenigstens ein erster Schalter zum Ein- und Ausschalten der Laserdiode, wenigstens ein zweiter Schalter zum Entladen interner Kapazitäten der Laserdiode im ausgeschalteten Zustand und wenigstens eine steuerbare Stromquelle integriert sind. Mit dieser Maßnahme wird erreicht, dass die während des Betriebs der Laserdiode aufgebauten internen Kapazitäten beim Abschalten schnell über den zweiten Schalter entladen werden können. Dadurch können Laserimpulse mit sehr schnell abfallenden Flanken erzeugt werden.

Um das ausgesendete Laserlicht der Laserdiode überwachen und steuern zu können, ist eine Monitordiode auf dem Halbleiterchip montiert.

Weiterhin kann eine Regelungseinrichtung vorgesehen sein, die an entsprechenden elektrischen Anschlusskontakten der Leiterplatte angeschlossen werden kann. Die Regelungseinrichtung ist mit der Monitordiode und dem Halbleiterchip elektrisch verbindbar, um so die Lichtleistung der Laserdiode regeln zu können.
Um die eingangs erwähnten schnellen Laserimpulse erzeugen zu können, ist es vorteilhaft, die Regelungseinrichtung im Halbleiterchip zu integrieren. In diesem Fall können wiederum sehr kurze elektrische Verbindungen mit möglichst kleinen Induktivitäten erreicht werden.

Die Bauteile der Schaltungsanordnung werden vorzugsweise über eine an die Leiterplatte anschließbare externe Energieversorgungseinrichtung gespeist.

Die Erfindung wird nachfolgend anhand zweiter Ausführungsbeispiele in Verbindung mit den beiliegenden Zeichnungen näher erläutert. Es zeigen:
- Fig. 1: eine Schaltungsanordnung zum Erzeugen schneller Laserimpulse, bei der die elektronischen und optoelektronischen Bauelemente auf einer Leiterplatte mit profilierter Oberfläche angeordnet sind,
- Fig. 2: eine erfindungsgemäße Schaltungsanordnung zum Erzeugen schneller Laserimpulse, bei der die elektrischen und optoelektronischen Bauteile an gegenüberliegenden Seiten der Leiterplatte angeordnet sind,
- Fig. 3: die in Fig. 2 gezeigte Schaltungsanordnung ohne Leiterplatte,
- Fig. 4: ein vereinfachtes elektrisches Ersatzschaltbild der in Fig. 1, oder 2 gezeigten Schaltungsanordnung.

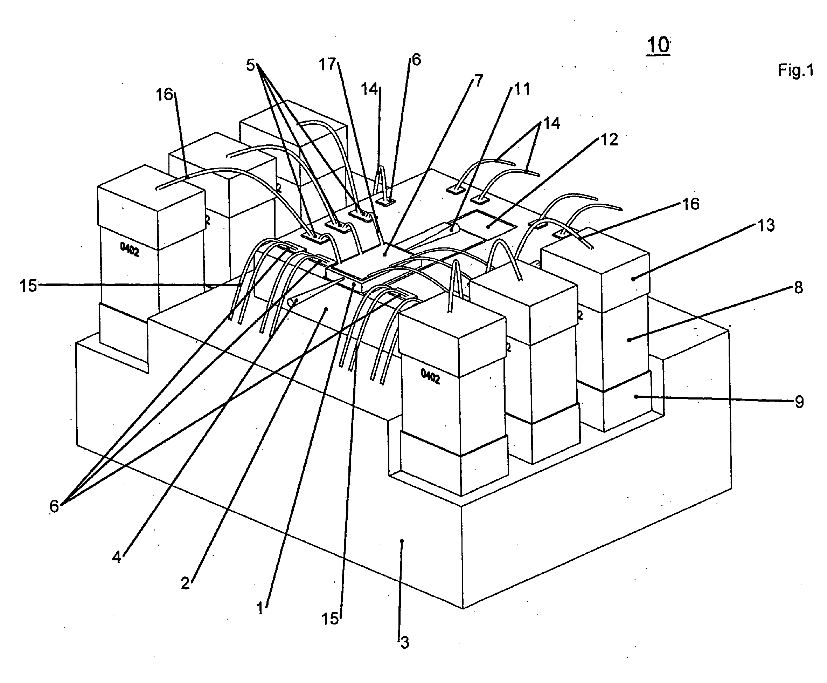

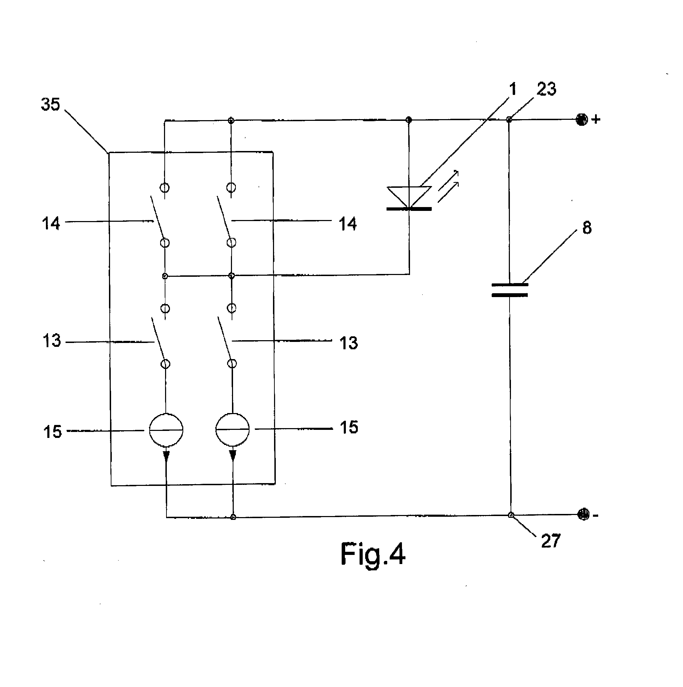

Fig. 1 zeigt eine erste beispielhafte Schaltungsanordnung 10 zum Erzeugen schneller Laserimpulse. Die Schaltungsanordnung 10 enthält eine Leiterplatte 3, die lediglich beispielhaft eine profilierte Oberfläche mit einem erhöhten mittleren Bereich und zwei tiefer liegenden Randbereichen aufweist. Auf dem erhöhten mittleren Bereich ist ein Halbleiterchip 2 beispielsweise aufgeklebt. In dem Halbleiterchip 2 ist ein nicht dargestellter Lasertreiber integriert, dessen beispielhaftes elektrisches Ersatzschaltbild in Fig. 4 dargestellt ist.

Auf dem Halbleiterchip 2 ist eine Laserdiode 1 beispielsweise mittels eines elektrisch leitfähigen Klebers montiert. Die Laserdiode 1 sendet im Betriebszustand an der Vorderseite ein Hauptlaserlicht 4 und an der gegenüberliegenden Rückseite ein abgeschwächtes Laserlicht 11 aus. Das an der Rückseite der Laserdiode 1 ausgesendete abgeschwächte Laserlicht 11 kann von einer Monitordiode 12 detektiert werden, die ebenfalls auf dem Halbleiterchip 2 angeordnet ist. Die Monitordiode 12 dient dazu, das erfasste abgeschwächte Laserlicht 11 in einen zum einfallenden Licht proportionalen Fotostrom umzuwandeln, der beispielsweise einer nicht dargestellten Regelungseinrichtung zum Regeln der Lichtleistung der Laserdiode 1 zugeführt werden kann. An dieser Stelle sei angemerkt, dass die Leiterplatte 3 Anschlusskontakte zum Anschalten einer solchen Regeleinrichtung enthalten kann. Die nicht dargestellte externe Regeleinrichtung kann über Leiterbahnen, die auf oder innerhalb der Leiterplatte 3 verlaufen, mit dem Lasertreiber des Halbleiterchips 2 verbunden werden. Bei einer vorteilhaften Ausführungsform kann die Regelungseinrichtung integrierter Bestandteil des Halbleiterchips 2 sein.

Auf den tiefer liegenden Randbereichen der Leiterplatte 3 sind Anschlusskontakte (nicht dargestellt) vorgesehen, die mit den Minus-Anschlüssen 9 jeweiliger Kondensatoren 8 verbunden werden können. Die Plus-Anschlüsse 13 der Kondensatoren 8 sind über Bonddrähte 16 mit Plus-Anschlüssen des Halbleiterchips 2 und auf diese Weise mit den Plus-Anschlüssen des Lasertreibers verbunden. Weiterhin führen Bonddrähte 17 vom Plus-Anschluss 7 der Laserdiode 1 zu den Plus-Anschlüssen 5 des im Halbleiterchip 2 integrierten Lasertreibers. Der im Halbleiterchip 2 integrierte Lasertreiber weist einen Masse- oder Minus-Anschlüsse 6 auf, der über Bonddrähte 14 mit einer entsprechenden Anschlussfläche auf der Leiterplatte 3 verbunden ist. Der Masseanschluss 6 kann auch auf der Rückseite des Halbleiterchips 2 angeordnet und mit einer entsprechenden Anschlussfläche der Leiterplatte 3 verbunden sein.

Dadurch, dass der Lasertreiber im Halbleiterchip 2 integriert ist, die Laserdiode 1 unmittelbar auf dem Halbleiterchip 2 aufsitzt und die Kondensatoren 8 in unmittelbarer Nähe des Halbleiterchips 2 und somit in unmittelbarer Nähe des Lasertreibers angeordnet sind, können sehr kurze Bonddrähte 14, 15, 16 und 17 verwendet werden, so dass die Induktivität der Bonddrähte möglichst klein gehalten werden kann.

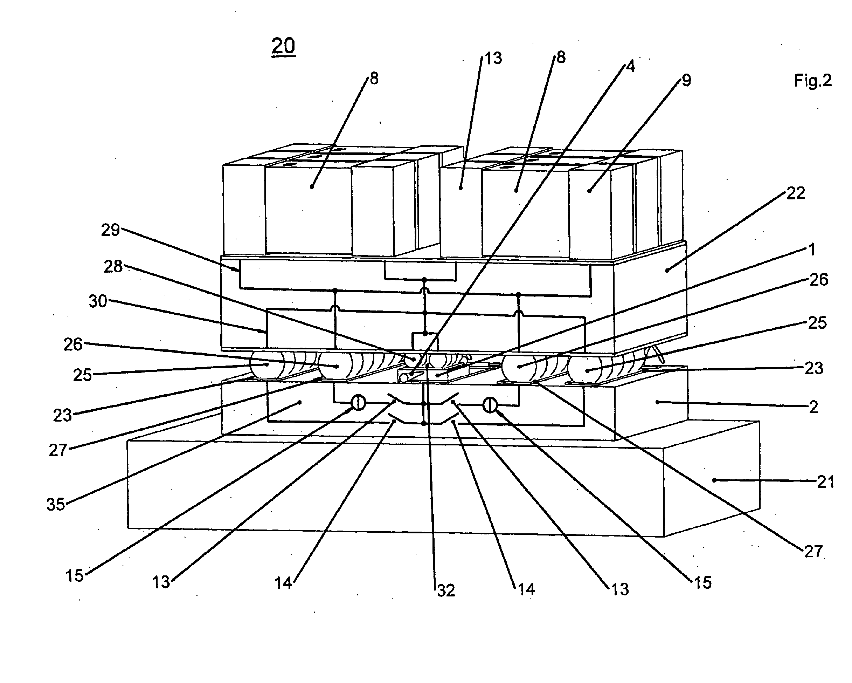

In Fig. 2 ist eine alternative Schaltungsanordnung 20 zum Erzeugen schneller Laserimpulse dargestellt. Hier werden für gleiche Bauteile die bereits in Fig. 1 verwendeten Bezugszeichen benutzt. Beispielsweise wird eine als Kühlkörper fungierende Trägerplatte 21 verwendet, auf der ein Halbleiterchip 2 beispielsweise aufgeklebt ist. Der Halbleiterchip 2 enthält wiederum einen nicht dargestellten Lasertreiber, der beispielhaft zwei parallel geschaltete Stromquellen 15 aufweist, die jeweils über einen Schalter 13 mit einer auf dem Halbleiterchip 2 angeordneten Laserdiode 1 elektrisch verbunden sind. Die Laserdiode 1 kann über Schalter 14 im ausgeschalteten Zustand kurzgeschlossen werden, um interne Kapazitäten schnell entladen zu können. Die Laserdiode 1 ist beispielsweise mittels eines elektrisch leitfähigen Klebers direkt auf dem Halbleiterchip 2 aufgebracht.

Ähnlich der in Fig. 1 gezeigten Schaltungsanordnung 10 ist hinter der Laserdiode 1 eine Monitordiode 12 auf dem Halbleiterchip 2 angeordnet. Der Halbleiterchip 2 weist zwei Plus-Anschlüsse 23 und zwei Minus-Anschlüsse 27 auf, die jeweils mit einem Schalter 14 beziehungsweise einer Stromquelle 15 des Lasertreibers 35 verbunden sind. Die Laserdiode 1 weist wiederum auf ihrer Oberseite einen Plus-Anschluss 32 auf. Auf dem Plus-Anschluss 23 und dem Minus-Anschluss 27 des Leitungstreibers sowie auf dem Plus-Anschluss 32 der Laserdiode 1 sind als elektrische Verbindungen Lötkugeln 25, 26 bzw. 28 mittels eines elektrisch leitfähigen Klebers befestigt. Auf den Lötkugeln 25, 26 und 28 ist eine Leiterplatte 22 aufgesetzt, wobei die Lötkugeln 25, 26 und 28 mit entsprechenden Kontaktflächen an der Leiterplatte 22 elektrisch verbunden sind. Auf der gegenüber liegenden Seite der Leiterplatte 22 sind Kondensatoren 8 montiert. Hierzu weist die Leiterplatte 22 elektrische Plus- und Minus-Anschlussflächen auf, die mit den Plusanschlüssen 13 und Minusanschlüssen 9 der jeweiligen Kondensatoren 8 verbunden sind. An oder innerhalb der Leiterplatte 22 verlaufen Leiterbahnen 29 und 30. Die Leiterbahnen 29 verbinden die Minusanschlüsse 9 der Kondensatoren 8 über die Lötkugeln 26 mit den Minuskontakten 27 des Lasertreibers 35, während die Leiterbahnen 30 die Plus-Anschlüsse 13 der Kondensatoren 8 über die Lötkugeln 26 mit den Plusanschlüssen 27 des Halbleiterchips 2 verbinden. Der Plus-Anschluss 32 der Laserdiode 1 ist über die Lötkugeln 28 und die Leiterbahnen 30 mit den Plus-Anschlüssen 13 der jeweiligen Kondensatoren 8 verbunden. Dadurch, dass die Kondensatoren 8, die Leiterplatte 22, die Laserdiode 1 sowie der Halbleiterchip 2 übereinander angeordnet sind und als elektrische Verbindungen Lötkugeln verwendet werden, kann eine kompakte Bauform mit sehr kurzen elektrischen Verbindungen erzielt werden. Auf diese Weise können die Induktivitäten der elektrischen Verbindungen klein gehalten werden.

Angemerkt sei, dass die Leiterplatte 22 nach Fig. 2 als auch die Leiterplatte 3 nach Fig. 1 Anschlusskontakte zum Anschalten einer elektrischen Versorgungsquelle (nicht dargestellt) aufweisen kann, die zur Energieversorgung des integrierten Lasertreibers 35, der Laserdiode 1, der Monitordiode 12 und der Kondensatoren 8 verwendet wird. Eine nicht dargestellte Regelungseinrichtung zum Regeln der Lichtleistung der Laserdiode 1 kann wiederum integraler Bestandteil des Halbleiterchips 2 sein oder extern über entsprechende Anschlusskontakte an der Leiterplatte 22 angeschlossen werden. In diesem Fall ist wiederum dafür zu sorgen, dass die Leiterplatte 22 Leiterbahnen aufweist, die die Regelungseinrichtung mit dem Lasertreiber 35 verbindet.

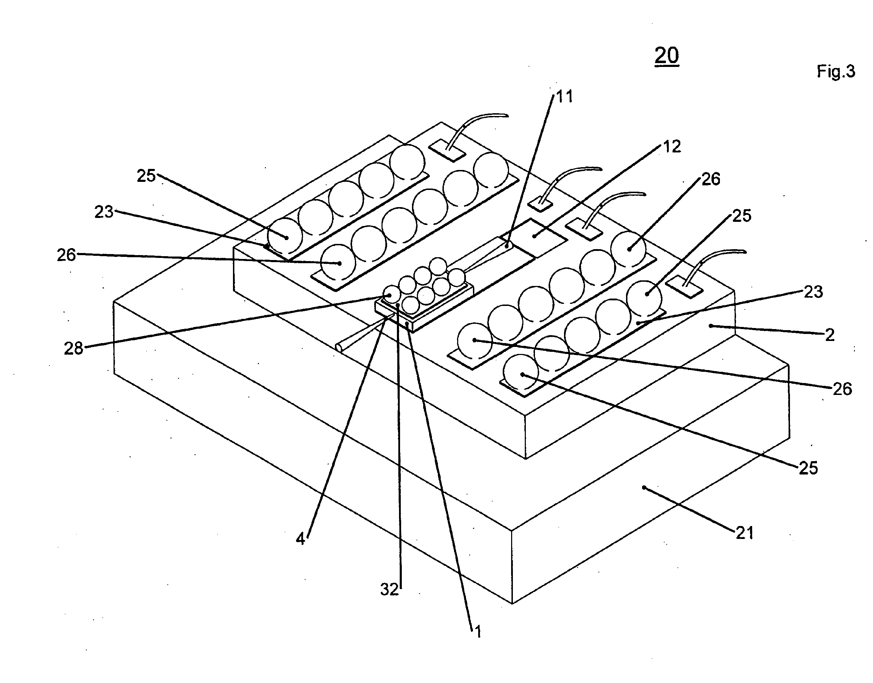

Fig. 3 zeigt die in Fig. 2 dargestellte Schaltungsanordnung 20 mit entfernter Leiterplatte 22. Insbesondere ist in Fig. 3 die gegenüber der Rückseite der Laserdiode 1 auf dem Halbleiterchip 2 montierte Monitordiode 12 dargestellt. Mit Bezugszeichen 4 ist der nach vorne gerichtete Hauptlaserstrahl der Laserdiode 1 dargestellt, während der nach hinten gerichtete abgeschwächte Laserstrahl mit Bezugszeichen 11 gekennzeichnet ist.

Nachfolgend wird die Funktionsweise der in Fig. 2 gezeigten Schaltungsanordnung 20 zum Erzeugen schneller Laserimpulse in Verbindung mit Fig. 4 näher erläutert. Das in Fig. 4 gezeigte elektrische Ersatzschaltbild des Lasertreibers 30 weist zwei parallel geschaltete steuerbare integrierte Stromquelle 15 auf, die mit den Minus-Anschlüssen 27 des Halbleiterchips 2 verbunden sind. Jede Stromquelle 15 kann über einen integrierten Schalter 13 mit dem Minus-Anschluss der Laserdiode 1 verbunden werden. Zwei parallel geschaltete integrierte Schalter 14 sind parallel zur Laserdiode 1 geschaltet. Die Schalter 13 und 14 sind beispielsweise als Feldeffekttransistoren implementiert. Die in Fig. 2 gezeigten Kondensatoren 8 sind in Fig. 4 symbolisch durch einen Kondensator 8 dargestellt. Die Kondensatoren 8 sind an die Plusanschlüsse 23 und die Minus-Anschlüsse 27 des Lasertreibers 35 angeschlossen. Eine nicht dargestellte Energieversorgungseinrichtung ist symbolisch durch das Plus- und Minuszeichen angedeutet.

Die Kondensatoren 8 dienen dazu, beim Schalten der Laserdiode 1, beispielsweise beim Schließen der Schalter 13 zusätzlich zu der von der nicht dargestellten Energieversorgungseinrichtung gelieferten Energie eine zusätzliche Energie der Laserdiode 1 zuzuführen, um Laserimpulse erzeugen zu können, die eine sehr kurze Anstiegszeit, das heißt vorzugsweise im Picosekundenbereich, zeitigen. Denn durch die kurzen elektrischen Verbindungen zwischen den Kondensatoren 8 und dem Lasertreiber 35 können die Kondensatoren 8 sehr schnell ihre Energie an die Stromquellen 15 abgeben.

Um sicherstellen zu können, dass die erzeugten Laserimpulse eine sehr kurze Abfallzeit, das heißt vorzugsweise im Picosekundenbereich, zeitigen, werden die Schalter 14 geschlossen, wenn die Schalter 13 geöffnet werden und somit die Laserdiode 1 abgeschaltet wird. Auf diese Weise wird die Laserdiode 1 über die Schalter 14 kurzgeschlossen und die während des Betriebs der Laserdiode 1 gebildeten internen Kapazitäten können sehr rasch entladen werden. Die Kondensatoren 8 müssen aufgrund der hohen Schaltgeschwindigkeiten der Schalter 13 und 14 gute Hochfrequenzeigenschaften aufweisen.

### Bezugszeichenliste

- 1: Laserdiode
- 2: Halbleiterchip
- 3: Leiterplatte
- 4: Hauptlaserlicht
- 5: Plus-Anschlüsse des Lasertreibers
- 6: Minus-Anschlüsse des Lasertreibers
- 7: Plus-Anschlüsse der Laserdiode
- 8: Kondensatoren
- 9: Minus-Anschlüsse der Kondensatoren
- 10: Schaltungsanordnung zum Erzeugen schneller Laserimpulse
- 11: abgeschwächter Laserstrahl
- 12: Monitordiode
- 13: Plus-Anschlüsse der Kondensatoren
- 14-17: Bonddrähte
- 20: alternative Schaltungsanordnung
- 21: Kühlkörper oder Trägerplatte
- 22: Leiterplatte
- 23: Plus-Anschlüsse des Lasertreibers
- 25, 26, 28: Lötkugeln
- 29, 30: Leiterbahnen
- 32: Plus-Anschlüsse der Laserdiode
- 35: Lasertreiber

## Patentansprüche

1. Schaltungsanordnung (10; 20) zum Erzeugen schneller Laserimpulse mit
einer Leiterplatte (3; 22),
einem auf der Leiterplatte (3; 22) montierten Halbleiterchip (2) mit einem integrierten Lasertreiber (35) zum Schalten einer Laserdiode (1), die auf dem Halbleiterchip (2) angeordnet und mit diesem elektrisch verbunden ist, mit
wenigstens einem, an der Leiterplatte (3; 22) montierten Kondensator (8), der elektrisch mit dem Halbleiterchip (2) verbunden ist, wobei der Kondensator (8) beim Schalten der Laserdiode (1) eine zusätzliche Energie an den Lasertreiber (35) abgibt, und wobei
der wenigstens eine Kondensator (8) an einer Seite der Leiterplatte (22) angeordnet ist,
der Halbleiterchip (2) und die Laserdiode (1) an einer anderen Seite der Leiterplatte (22) angeordnet sind, und die Leiterplatte (22) Leiterbahnen (29, 30) aufweist, die an der einen Seite der Leiterplatte (22) mit dem wenigstens einen Kondensator (8) und an der anderen Seite über Lötkugeln oder elektrisch leitfähige, vorzugsweise kugelförmige Elemente (25, 26, 28) mit dem Halbleiterchip (2) und der auf dem Halbleiterchip (2) angeordneten Laserdiode (1) verbunden sind.

2. Schaltungsanordnung nach Anspruch 1,
**dadurch gekennzeichnet, dass**
der Halbleiterchip (2) wenigstens einen ersten Schalter (13) zum Ein- und Ausschalten der Laserdiode, und wenigstens eine steuerbare Stromquelle (15) aufweist.

3. Schaltungsanordnung nach Anspruch 2,
**dadurch gekennzeichnet, dass**
der Halbleiterchip (2) wenigstens einen zweiten Schalter (14) zum Entladen interner Kapazitäten der Laserdiode (1) im ausgeschalteten Zustand aufweist.

4. Schaltungsanordnung nach einem der Ansprüche 1 bis 3,
**dadurch gekennzeichnet, dass**
auf dem Halbleiterchip (2) eine Monitordiode (12) zum Überwachen der Lichtleistung der Laserdiode (1) montiert ist.

5. Schaltungsanordnung nach Anspruch 4,
**dadurch gekennzeichnet, dass**
die Leiterplatte (3; 22) elektrische Kontakte zum Anschalten einer Regelungseinrichtung, die mit der Monitordiode (12; 70) und dem Halbleiterchip (2) elektrisch verbindbar ist, aufweist.

6. Schaltungsanordnung nach Anspruch 4,
**dadurch gekennzeichnet, dass**
in dem Halbleiterchip (2) eine Regelungseinrichtung zum Regeln der Lichtleistung der Laserdiode (1) integriert ist.

## Claims

1. A circuit arrangement (10; 20) for producing fast laser pulses, comprising:
a printed circuit board (3; 22);
a semiconductor chip (2) mounted on the printed circuit board (3; 22) and including an integrated laser driver (35) for switching a laser diode (1) which is arranged on and electrically connected with the semiconductor chip (2);
at least one capacitor (8) mounted on the printed circuit board (3; 22), which is electrically connected to the semiconductor chip (2);
wherein upon switching of the laser diode (1) said capacitor (8) delivers additional energy to the laser driver (35); and wherein
the at least one capacitor (8) is arranged on one side of the printed circuit board (22), the semiconductor chip (2) and the laser diode (1) are arranged on another side of the printed circuit board (22), and the printed circuit board (22) includes conductive traces (29, 30) which on the one side of the printed circuit board (22) are connected to the at least one capacitor (8), and on the other side to the semiconductor chip (2) and the laser diode (1) arranged on the semiconductor chip (2) via solder balls or electrically conductive, preferably spherical elements (25, 26, 28).

2. The circuit arrangement according to claim 1, **characterized in that** the semiconductor chip (2) includes at least one first switch (13) for switching on and off the laser diode, and at least one controllable power source (15).

3. The circuit arrangement according to claim 2, **characterized in that** the semiconductor chip (2) includes at least one second switch (14) for discharging internal capacities of the laser diode (1) in the off state.

4. The circuit arrangement according to any of claims 1 to 3, **characterized in that** a monitor diode (12) is mounted on the semiconductor chip (2) for monitoring the light power of the laser diode (1).

5. The circuit arrangement according to claim 4, **characterized in that** the printed circuit board (3; 22) has electrical terminals for connecting control means which are electrically connectable to the monitor diode (12; 70) and the semiconductor chip (2).

6. The circuit arrangement according to claim 4, **characterized in that** the semiconductor chip (2) includes an integrated control means for controlling the light power of the laser diode (1).

## Revendications

1. Circuit (10 ; 20) pour la génération d'impulsions laser rapides, comportant
une plaquette imprimée (3 ; 22),
une puce semi-conductrice (2) montée sur la plaquette imprimée (3 ; 22) avec une commande de laser (35) intégrée pour la commutation d'une diode laser (1) disposée sur la puce semi-conductrice (2) et électriquement reliée à celle-ci, comportant
au moins un condensateur (8) monté sur la plaquette imprimée (3 ; 22) et électriquement relié à la puce semi-conductrice (2), ledit condensateur (8) fournissant une énergie complémentaire à la commande de laser (35) lors de la commutation de la diode laser (1),
et le ou les condensateurs (8) étant disposés sur une face de la plaquette imprimée (22), la puce semi-conductrice (2) et la diode laser (1) sur une autre face de la plaquette imprimée (22), et la plaquette imprimée (22) présentant des pistes conductrices (29, 30) reliées sur la première face de la plaquette imprimée (22) au ou aux condensateurs (8), et sur l'autre face à la puce semi-conductrice (2) et à la diode laser (1) disposée sur la puce semi-conductrice (2) par des billes de brasage ou par des éléments (25, 26, 28) électriquement conducteurs, préférentiellement sphériques.

2. Circuit selon la revendication 1, **caractérisé en ce que**
la puce semi-conductrice (2) comporte au moins un premier commutateur (13) pour l'activation et la désactivation de la diode laser, et au moins une source de courant (15) pouvant être commandée.

3. Circuit selon la revendication 2, **caractérisé en ce que**
la puce semi-conductrice (2) comporte au moins un deuxième commutateur (14) pour la décharge de capacités internes de la diode laser (1) en état de désactivation.

4. Circuit selon l'une des revendications 1 à 3, **caractérisé en ce que**
une diode de contrôle (12) est montée sur la puce semi-conductrice (2) pour surveiller la puissance lumineuse de la diode laser (1).

5. Circuit selon la revendication 4, **caractérisé en ce que**
la plaquette imprimée (3 ; 22) présente des contacts électriques pour la connexion d'un dispositif de régulation pouvant être électriquement relié à la diode de contrôle (12 ; 70) et à la puce semi-conductrice (2).

6. Circuit selon la revendication 4, **caractérisé en ce que**
un dispositif de régulation est intégré dans la puce semi-conductrice (2) pour réguler la puissance lumineuse de la diode laser (1).
